# EUROPEAN PATENT SPECIFICATION

(11) **EP 2 777 092 B1**
(45) Date of publication and mention of the grant of the patent: **23.05.2018**
(21) Application number: 12798343.5
(22) Date of filing: 05.11.2012
(51) Int. Cl.: H01Q 1/24, H03H 7/46, H01P 1/213

(54) **COMBINING APPARATUS FOR USE IN SIGNAL TRANSMITTING AND/ OR RECEIVING APPARATUS**
KOMBINIERTE VORRICHTUNG ZUR VERWENDUNG IN EINER VORRICHTUNG ZUM SENDEN UND/ODER EMPFANGEN VON SIGNALEN
APPAREIL DE COMBINAISON POUR UTILISATION DANS UN APPAREIL D'ÉMISSION ET/OU DE RÉCEPTION DE SIGNAL

(30) Priority: 07.11.2011 GB 201119191
(43) Date of publication of application: 17.09.2014
(73) Proprietor: Radio Design Limited, West Yorkshire BD17 7DW (GB)
(72) Inventor: SLEIGH, Philip, Ilkley, West Yorkshire LS29 0QE (GB); GOSTLING, Martin, Leeds, West Yorkshire LS19 6QQ (GB)
(74) Representative: Tomkinson, Alexandra
(86) International application number: PCT/GB2012/052752
(87) International publication number: WO 2013/068728

(56) References cited:
- WO-A1-2006/071005
- WO-A1-2006/121402
- GB-A- 2 444 786

## Description

This invention relates to combining apparatus for apparatus which is used for the transmission and/or receiving of data signals and particularly, although not necessarily exclusively, to combining apparatus for use in a wireless communication network.

A wireless communication network typically includes a plurality of cell sites which allow radio frequency (RF) signals to be transmitted to and received from mobile phone units. Each cell site typically includes a mast, at the top of which is typically mounted an antenna for transmitting and/or receiving one or more radio frequency signals and optionally a tower mounted amplifier (TMA) for amplifying the radio frequency signals from the antenna to a base transceiver station (BTS), typically located at the base of the mast and which is connected to the TMA, if provided, and antenna via two feeder cables. The BTS typically includes a transceiver that generates one or more radio frequency signals for transmission to a mobile phone unit, as well as receiving one or more radio frequency signals from the mobile phone unit.

Conventionally the wireless connections between a cell site and a mobile phone unit have been made using two or three frequency bands per region. For example, in the UK these frequency bands are at 900MHz, 1800MHz and 2100MHz. Each frequency band has also conventionally been assigned to a particular technology; the 900MHz and 1800MHz bands have typically been licensed for second generation (2G) system use only, and the 2100MHz band has been licensed for third generation (3G) system use. As 3G systems support higher data rates than 2G systems, the licenses for frequency bands previously restricted to 2G systems only have now been amended to allow 3G systems and potentially fourth generation (4G) systems to be deployed within them. In addition, further bandwidth is being made available via freeing up additional frequency bands. Mobile communication operators therefore need to invest significant amounts of money in their networks to provide the latest technologies in multiple bands whilst continuing to support legacy technology/band combinations. Consequently, mobile communication operators are under pressure to reduce capital expenditure (CAPEX) and operating expenditure (OPEX) wherever possible in their wireless communication networks.

A significant opportunity for cost saving for a mobile communication operator is sharing of network infrastructure in that a single operator can share infrastructure between equipment operating in different bands or operating in the same band and utilising different technologies (e.g. 2G and 3G) and/or the infrastructure can be shared between two different operators.

Typically, a BTS at a cell site is needed for each frequency band, each operator and each technology. A common cell site configuration comprises splitting the area to be covered by the wireless communications network into three 120 degree sectors, with each sector serviced by an antenna configuration that provides a pair of statistically independent reception and/or transmission paths to the mobile phone units. There are several methods for producing such an antenna configuration including spatial diversity and X-polarised antennas. The feeder cables, TMAs and antennae are often referred to as an antenna system. In all cases the antenna systems will have a pair of ports, each port associated with one of the statistically independent paths. Within each sector the cell site may transmit on one or both antenna ports but it will receive on both. The use of two statistically independent paths for receiving a signal is referred to as receive diversity and improves the sensitivity of the BTS receiver. Receiver sensitivity directly impacts the cell site coverage and capacity.

It is known to be able to provide combiner apparatus that facilitates sharing of apparatus which is required to operate for both operators using different frequency sub bands located within a wider, known, frequency band by combining the signals from the respective BTS's onto the common antenna system and, in turn splits combined signals from the common antenna to the respective BTS's. The applicant has co-pending patent applications which define such apparatus.

Generally the provision of combiner apparatus that allows two BTS's that operate in a single frequency band to share an antenna system is challenging as the guard band between the respective operating radio frequency sub bands of the BTS's can be small and this in turn reduces the isolation between input ports of the combining apparatus which can possibly lead to transmitter noise generated by one BTS, falling within the receive band, leaking through the combining apparatus into the other BTS, thereby desensitising its receiver and reducing its coverage and uplink capacity. A further problem which is found is that while the known combiner systems will operate successfully, the need for high isolation between the respective sub bands of the frequency range means that relatively high performance filters are required to be provided as part of the system. These filters can be relatively large and therefore difficult to physically fit in the available space or require the BTS to be relatively large. These filters are also relatively expensive components which can reduce the cost advantage to be gained by sharing infrastructure. It is known, for example, from the applicant's application GB1114106.6 to partially mitigate this problem by allowing a higher signal loss in the Receiving signal path if the TMA is provided which in turn allows smaller and less expensive filters to be used in the receiving signal path but there is still a need for the larger more expensive filters to be used in the transmitting path.

Patent US7941187 discloses combiner apparatus in which a network including hybrid couplers and filters are used. This configuration provides good BTS to BTS isolation regardless of the filter performance and therefore filters that are simpler, for example, than the filters required to be provided in the transmit signal path in the system of GB114106.6, can be used. However, the filters in US7941187 still have to provide sufficient selectivity in operation in order to be able to differentiate between frequency sub-bands and this level of complexity is required in the filters provided in both transmit and receive signal paths and therefore the receive filters used in US7941187 are larger and more complicated than the receive signal path filters used in GB1114106.6.

WO2006/071005 discloses wireless communication base station sharing apparatus for sharing one antenna between a main system and a subsystem. In the apparatus, a first signal combiner/distributor is connected to a transmission/reception signal line of a main system duplexer through a first port, distributes a signal received through the first port to second and third ports, combines the signals received through the second and third ports according to the phases of the signals, and provides the combined signal through the first port or a fourth port. A second signal combiner/distributor is connected to a transmission /reception signal line of a subsystem duplexer through a fifth port and the antenna through an eight port, distributes a signal received through the fifth port to sixth and seventh ports, combines the signals received through the sixth and sevenths ports according to the phases of the signals, and provides the combined signal through the fifth and eighth port. A first filter is provided in a signal path between the second port of the first signal combiner/distributor and the sixth port of the second signal combiner/distributor. A second filter is provided in a signal path between the third port of the first signal combiner/distributor and the seventh port of the second signal combiner/distributor.

WO2006/121402 discloses a filter combiner adapted to be connected to an antenna. It comprises a first directional coupler connected to at least one first filter, to an antenna branch, to at least one second filter and to a first signal branch. The combiner also comprises a second directional coupler connected to the at least first filter, to a second signal branch and to the at least one second filter. The first directional coupler is adapted to be connected to the first signal branch via at least one third filter.

It is therefore an aim of the present invention to provide combining apparatus, and a method of operation of the same that overcomes the above mentioned problems.

In a first aspect of the invention there is provided combining apparatus for use in wireless communication apparatus including an antenna for receiving and/or transmitting signals and at least first and second base transceiver stations (BTS), said antenna in communication with each BTS, said received and/or transmitted signals passing between said antenna and the respective BTS via said combining apparatus, the combining apparatus includes one or more filters in the received signal paths which are tuned to allow the signals received within the said known frequency band to pass through the same and wherein the filters for the received signals are tuned such that they have substantially the same return and insertion loss values.

Typically means are provided at the respective base transceiver stations to select and use the received signals which lie in their respective required frequency sub band.

Typically the filters for the received signals are tuned such that they have substantially the same return loss as insertion loss.

Typically the filters for the received signals are tuned to have substantially 3dB return and insertion losses which provides substantially the same power of received signals across the known frequency band to both base transceiver stations. The power of the signal at both base transceiver stations is found to be sufficient to allow the required frequency signals to be obtained and used by the respective base transceiver stations.

In accordance with the invention the filters provided in the received signal path of the combining apparatus are only required to be able to distinguish between signals which are received within the known frequency band for the received signals, and those that are not. Those signals which are received within the known frequency band are allowed to pass through the same and those that are not, such as, for example, transmitted signals which are transmitted outside the known or predetermined frequency band, are not allowed to pass through the filters. This ability to use filters which allow the entire known frequency band to pass therethrough rather than specific sub bands of the same greatly simplifies the construction of the filters which are required to be used and hence reduces the size and expense of the same in contrast to those required to be used in previous systems.

In one embodiment a signal that is received and which falls in the receive frequency sub-band of either of the base station transceivers passes to the combining apparatus and the signal is split with the combining apparatus providing a phase difference between the part of the signal passed to a first receiving signal filter and the other part of the signal which is passed to a second receiving signal filter, said filters having a frequency passband which defines the range of frequencies which can pass through the same and within which the said received signal falls.

In one embodiment the filters are tuned to have an insertion loss and return loss values which are substantially equal. Typically the insertion loss value and the return loss value is 3dB such that each filter will allow substantially half the signal applied to them to pass through and reflect substantially half the signal.

Typically the reflected signals recombine in phase at the port from the combining apparatus to one of the base transceiver stations and the signals that have passed through the filters recombine in phase and pass to the other of the base transceiver stations.

Thus, received signals that are associated with either of the base transceiver stations are split in two by the combining apparatus with half the power passing to each base transceiver station and the receive filters are only required to distinguish between signals received in a predetermined frequency band and those signals transmitted in a different frequency band rather than between receive signals that fall within two receive sub-bands and therefore the filters used can be of a considerably simpler design.

Typically the apparatus includes at least two signal splitting/combining networks. Typically the said networks are located in the combining apparatus such that one is positioned between the filters on one side and a port of a first base transceiver station and a port to the antenna on the other side, and the other network is positioned between the filters and a port of the second base transceiver station.

Typically each of the base transceiver stations requires to transmit signals in different frequency sub bands of a predetermined frequency band and in accordance with the invention the filters provided in the transmit path are provided such as to allow the passage through the same of signals transmitted from one of the base transceiver stations in one of the said sub bands while those signals transmitted from the other base transceiver station in another frequency sub band are rejected by the filters and pass to the antenna.

In one embodiment a signal transmitted by one of the base transceiver stations enters one of the splitting/combining networks and is split in two with substantially half the signal passing to one of the transmit signal path filters and half to the other of the transmit signal path filters.

In one embodiment the splitting/combining network is designed such that there is a phase difference between the signals passed to the said filters. Typically the said filters are tuned to have substantially the same performance and therefore the signals that they pass to the second of the signal splitting/combining networks remains out of phase by the same amount.

Typically the said signal splitting/combining network is designed such that the transmit signal parts are recombined in phase at the port to the antenna and cancelled at the port to other of the base transceiver stations such that signals transmitted by the first base transceiver station pass to the antenna and are isolated from the other of the base transceiver stations.

Typically the signals that are transmitted by the other of the said base transceiver stations enter the second of the splitting/combining networks and are split in two with substantially half the signal passing to a first set of transmit and receive filters and the other half passing to a second set of transmit and receive filters with a phase difference between the signal parts , said signals falling in the stopbands of all of the filters such that the signals are reflected and recombined in phase to pass to the antenna.

In one embodiment the received signals are received within a known frequency band and received signals in a first sub-band of said known frequency band are received by the first BTS and received signals in a second sub-band of said known frequency band are received by the second BTS. In one embodiment the second sub-band is distinct from the first sub-band.

In a further aspect of the invention there is provided wireless communication apparatus including an antenna for receiving and transmitting signals and at least first and second base transceiver stations (BTS), said antenna in communication with each BTS with said received and/or transmitted signals passing between said antenna and the BTS via combining apparatus including a plurality of filters, wherein the filters provided for transmitted signals allow those transmitted signals in a frequency sub-band of a predetermined frequency band used by one of the first or second BTS to pass therethrough and the filters provided for received signals allow signals in the frequency sub-band used by both of the said first and second BTS to pass therethrough to each of the first and second BTS and means are provided at each BTS to allow the selection of the received signals in their respective required sub-band wherein the filters for the received signals are tuned such that they have substantially the same return and insertion loss values.

In one embodiment the filters for received signals allow signals to pass through which are within a known frequency band, and which frequency band may be wider than that defined by the highest and lowest frequency values of said frequency sub bands required by the said first and second base transceiver stations.

In a further aspect of the invention there is provided a method of transmitting and receiving data signals to and from an antenna which is connected to at least two base transceiver stations (BTS), said method including the steps of; passing the transmitted and received signals to combining apparatus which allows the passage of received signals within a predetermined frequency band to the BTS and allow the combining of signals transmitted from the BTS to the antenna by providing filters in the combining apparatus which allow signals transmitted in a frequency sub-band used by only one of the BTS to pass therethrough and wherein a filter is provided in a combining apparatus for the received signals which is tuned to allow signals received in different frequency sub-bands used by the respective first and second BTS to pass therethrough and be received by both BTS wherein the filters for the received signals are tuned such that they have substantially the same return and insertion loss values.

Typically the filters for the received signals are tuned to have a 3dB insertion loss and a 3dB return loss, thereby allowing the strength of the signals to be substantially the same when received at both of the base transceiver stations.

It should be noted that although reference is made to first and second base transceiver stations, the invention may be implemented with three or more base transceiver stations in communication with a common antenna.

Specific embodiments of the invention are now described with reference to the accompanying drawings wherein;
Figure 1 illustrates in a schematic manner receiving and transmitting apparatus of the type to which the invention relates;
Figure 2 illustrates the arrangements of filters in combining apparatus in accordance with the invention; and
Figure 3 illustrates a further embodiment of the combining apparatus.

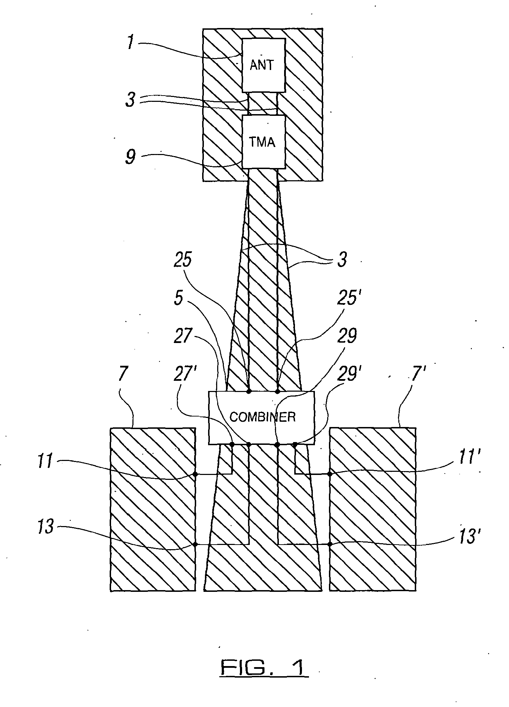

Referring firstly to Figure 1 there is illustrated a schematic elevation of one type of wireless communication apparatus of the type with which the invention is provided to be used. The apparatus includes antenna 1 and it should be noted that this antenna can be formed from several antennas each of which covers a particular sector from the antenna mast, such as for example, three antennas spaced around the central longitudinal axis and each covering 120 degrees. For the purpose of the description, only one antenna "sector" is described and the invention herein described can, if required, be used for each of the antenna sectors. The antenna in this embodiment is connected to a tower mounted amplifier 9 via cables 3 which allows received signals to be amplified before passing via cables 3 to a combining apparatus 5. The combining apparatus is in turn connected to first and second base transceiver stations 7, 7'. In one embodiment the first base transceiver station 7 is operated by a first service provider who transmits and receives signals at frequencies within two sub bands, a first sub band within a known frequency band for transmission and a second sub band within a known frequency band for receiving signals. The second base transceiver station 7' is operated by a second service provider which will also transmit and receive signals over two frequency sub bands within the respective known frequency bands but which sub bands are different to those used by the first service provider. The respective transceiver base stations are provided with connections 11,13 and ports 27,27' and 11', 13' and ports 29,29' respectively to allow the transmission and receipt of signals to and from the combining apparatus 5. In operation there is a need for the combining apparatus to ensure that the appropriate signals are received at each of the base transceiver stations in order to allow each of the service providers to maintain their service to their customers via the common antenna. The combining apparatus 5 in this embodiment includes a pair of input and output ports connected to the cables 3.

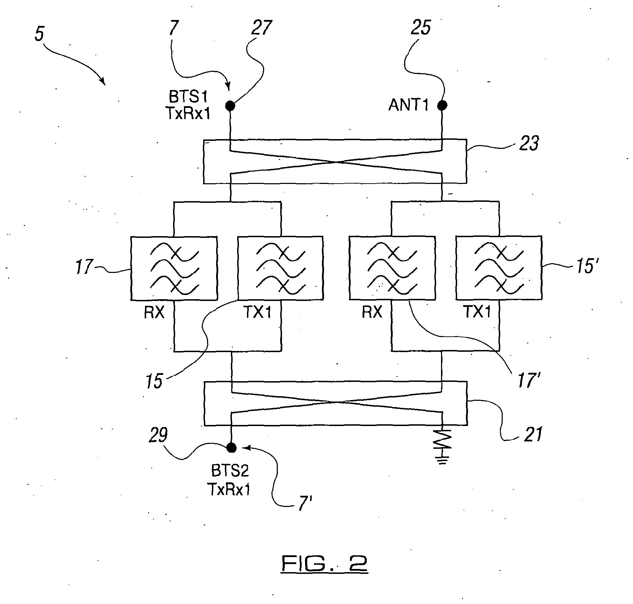

Referring now to Figure 2 there is illustrated a manner in which signals are allowed to pass through the combining apparatus 5. The combining apparatus 5 includes a plurality of filters, with filters 15 and 15' being provided in relation to the transmitted signals and filters 17 and 17' being provided in relation to the received signals. The combining apparatus includes an input/output ports 25, 25' that are connected to antenna 1 via cables 3 and TMA 9. The combining apparatus includes an input/output port 27 that is connected via cables 3 to the first BTS 7 and an input/output port 29 that is connected via cables 3 to the second BTS 7'. Filters 15 and 17 are connected in parallel and filters 15' and 17' are connected in parallel. The passbands of filters 15 and 15' cover the frequency sub-band associated with the transmit signals of one of the base transceiver stations, in this case BTS 7'. The passbands of filters 17 and 17' cover the sub-bands associated with the receive frequencies of both the first base transceiver station 7 and second base transceiver station 7'. The apparatus includes a pair of signal splitting/combining networks 21 and 23.

In use, and referring firstly to a signal transmitted by the second BTS 7' the signal enters the splitting/combining network 21 via input/output port 29 and is split in two with substantially half the signal passing to filter 15 and half to filter 15'. The splitting/combining network is designed such that there is a phase difference between the signals passed to filters 15 and 15'. Filters 15 and 15' are tuned to have substantially the same performance and therefore the signals that they pass to signal splitting/combining network 23 remain out of phase by the same amount. The splitting/combining network 23 is designed such that the transmit signals are recombined in phase at input/output port 25 and cancel at input/output port 27. Therefore, signals transmitted by the second BTS 7' pass to the antenna 1 and are isolated from the first BTS 7. The isolation is provided by the overall network topology rather than the filters themselves and therefore filters 15 and 15' can be provided of lower performance characteristics than would conventionally be required.

Referring to signals that are transmitted by the first BTS 7 they enter the splitting/combining network 23 via input/output port 27 and are split in two with substantially half the signal passing to filters 15 and 17 and half to filters 15' and 17'. The splitting/combining network is designed such that there is a phase difference between the signals passed to filters 15 and 17 and filters 15' and 17'. These signals fall in the stopbands of filters 15, 15', 17 and 17' and therefore are reflected. The splitting/combining network 23 is designed such that the signals recombine in phase at input/output port 1. Therefore, signals transmitted by the first BTS 7 pass to the antenna 1.

In contrast, the filters 17 and 17' for received signals are tuned so as to have substantially 3dB return loss and 3dB insertion loss. Return loss is a measure of how much power that is inserted into a port is reflected and uses a logarithmic scale to define this. 3dB is equivalent to half the power being reflected. Insertion loss is a measure of the proportion of the inputted power that makes its way through the network. In conventional filter systems return loss would be about 20dB, equivalent to 1% of the power reflected and insertion loss varies, typically between 0.1dB and 1dB, equivalent to between 98% and 79% of the inputted power passing through the filter. It will therefore be appreciated that the positive step of tuning the filters 17 and 17' to have 3dB return and insertion losses, thereby having substantially a 50% value for each differs significantly from the conventional approach. The result of this with the filter arrangement shown in Figure 2 is that all of the received signals within a predetermined or known frequency band are split, and, with the selection of 3dB, split substantially equally, between, and received by, the two base transceiver stations 7,7'. This therefore means that the filters can be relatively simple in form as they are not required to be provided to only allow signals in a relatively tightly controlled frequency sub band to pass therethrough but instead are provided to allow all signals received in a wider known or predetermined frequency band to pass therethrough. This known or predetermined frequency band will include therein the two frequency sub bands used by the respective base transceiver stations and as each base transceiver station will receive all the signals in the wider known or predetermined frequency band, the base transceiver stations can use the received signals which they require and ignore the remainder.

Referring to a signal that is received by antenna 1 and which signal falls in the said known frequency band and in which the receive frequency sub-bands of the first BTS 7 or the second BTS 7' fall, the signal passes to the antenna port 25 of the combining apparatus 5 via cables 3 and TMA 9. The splitting/combining network 23 splits the signal with substantially half the signal passing to filters 15 and 17 and half to filters 15' and 17'. The splitting/combining network is designed such that there is a phase difference between the signal part which is passed to filters 15 and 17 and the signal part which is passed to filters 15' and 17'. The signal falls in the passband of filters 17 and 17' and as both the insertion loss and return loss are substantially 3dB, each filter allows substantially half the signal applied to them to pass through and reflects substantially half the signal. The splitting/combining network 23 is designed such that the reflected signals recombine in phase at port 27 and pass to the first BTS 7 and the signals that have passed through filters 17 and 17' recombine in phase at port 29 and pass to the second BTS 7'. Therefore, receive signals that are associated with either BTS are split in two by the combining apparatus 5 with half the power passing to each BTS. The receive filters 17 and 17' are only required to distinguish between receive and transmit signals rather than between receive signals that fall within two receive sub-bands that therefore can be of a considerably simpler design.

Figure 2 illustrates one unit of the apparatus in accordance with the invention. In certain instances it may be required that multiples of the units are provided to operate together and in which case the same may be provided at the same location and each of the units connected to the antenna and TMA via one of the cables 3, with figure 1 illustrating two cable connections 3, each of which can be connected to a unit of the apparatus as described in Figure 2.

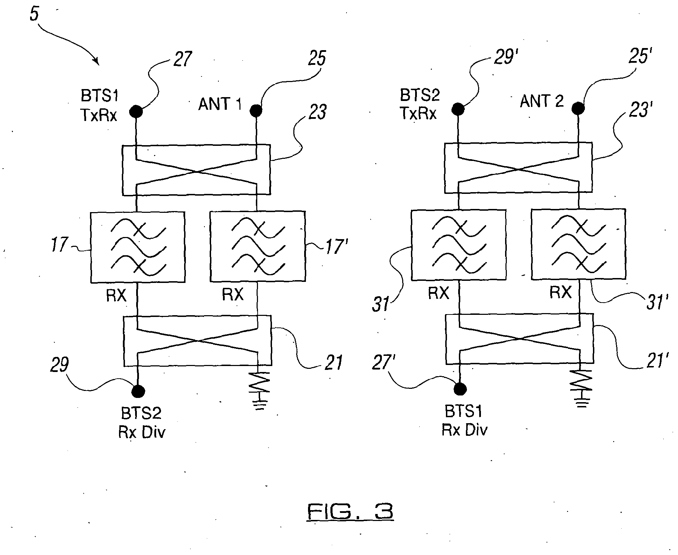

Referring now to Figure 3 there is illustrated a further embodiment which allows the passage of the signals through the combining apparatus 5. In this embodiment the combining apparatus includes a plurality of filters with filters 17,17', 31, 31' provided with respect to the received signals. The combining apparatus includes input/output ports 25, 25' connected to antenna 1 via cables 3 and TMA 9. The combining apparatus also includes an input/output port 27 and an output port 27' which are connected via cables 3 to the first BTS 7. Input/output port 29' and output port 29 are connected via cables 3 to the second BTS 7'. The ports 11, 11' of the respective BTS' 7, 7' can be used, if required, for both transmitting and receiving signals and are connected to ports 27 and 29' of the combining apparatus, respectively. The ports 13 and 13' of BTSs 7 and 7' can be used for receiving signals and are connected to ports 27' and 29 of the combining apparatus, respectively. The passbands of filters 17, 17', 31 and 31' cover the sub-bands associated with the received frequencies of both the first base transceiver station 7 and second base transceiver station 7'. In this embodiment the apparatus includes two pairs of signal splitting/combining networks 21 and 23 and 21' and 23'.

In use, and referring firstly to a signal transmitted by the first BTS 7, that signal enters the splitting/combining network 23 via input/output port 27 and is split in two, with substantially half the signal passing to filter 17 and half to filter 17'. The splitting/combining network is designed such that there is a phase difference between the signals which are respectively passed to filters 17 and 17'. The transmitted signal falls in the stop band of filters 17 and 17' and is therefore reflected. The splitting/combining network 23 is designed such that the transmitted signal is recombined in phase at input/output port 25 and cancelled at input/output port 27 and so signals which are transmitted by the first BTS 7 pass to the antenna 1 and no transmit band filters are required thus providing a clear advantage over the prior art.

Referring to a signal transmitted by the second BTS 7', the signal enters the splitting/combining network 23' via input/output port 29' and is split in two, with substantially half the signal passing to filter 31 and half to filter 31'. The splitting/combining network is designed such that there is a phase difference between the signals which are respectively passed to filters 31 and 31'. The transmitted signal falls in the stop band of filters 31 and 31' and is therefore reflected. The splitting/combining network 23' is designed such that the transmitted signal is recombined in phase at input/output port 25' and cancelled at input/output port 29' and so signals transmitted by the first BTS 7 pass to the antenna 1 and no transmit band filters are required, thus providing a clear advantage over the prior art.

The filters 17, 17', 31 and 31' for received signals are tuned so as to have substantially 3dB return loss and 3dB insertion loss. As a result, the filter arrangement shown in Figure 3 causes all of the received signals within a predetermined or known frequency band to be split, and, with the selection of 3dB, split substantially equally, between, and received by, the two base transceiver stations 7,7'. This therefore means that the filters can be relatively simple in form as they are not required to be provided to only allow signals in a relatively tightly controlled frequency sub band to pass therethrough but, instead, are provided to allow all signals received in a wider known or predetermined frequency band to pass therethrough. This known or predetermined frequency band will include therein the two frequency sub bands used by the respective base transceiver stations and, as each base transceiver station will receive all the signals in the wider known or predetermined frequency band, the base transceiver stations can use the received signals which they require and ignore the remainder.

Referring now to a signal that is received by antenna 1 and which signal falls in the said known frequency band and in which the receive frequency sub-bands of the first BTS 7 or the second BTS 7' fall, the signal passes to the antenna port 25 or 25' of the combining apparatus 5 via cables 3 and TMA 9. It should be noted that the following describes a signal passed to antenna port 25 but also applies to a signal passed to antenna port 25'. The splitting/combining network 23 splits the signal with substantially half the signal passing to filter 17 and half to filter 17'. The splitting/combining network is designed such that there is a phase difference between the signal part which is passed to filters 17 and the signal part which is passed to filter 17'. The signal falls in the passband of filters 17 and 17' and, as both the insertion loss and return loss are substantially 3dB, each filter allows substantially half the signal applied to them to pass through and reflects substantially half the signal. The splitting/combining network 23 is designed such that the reflected signals recombine in phase at port 27 and pass to the first BTS 7 and the signals that have passed through filters 17 and 17' recombine in phase at port 29 and pass to the second BTS 7'. Therefore, received signals that are associated with either BTS are split in two by the combining apparatus 5 with half the power passing to each BTS. Thus the receive filters 17 and 17' are only required to distinguish between receive and transmit signals rather than between receive signals that fall within two receive sub-bands and so the receive filters can be of a considerably simpler design that those used in the prior art.

The combining apparatus illustrated in Figure 3 allows two BTSs, each of which transmits signals on one antenna port and receives signals on two, to share an antenna system. The combining apparatus requires no transmit band filters and the receive band filters are of a simple design and therefore provide considerable size and cost advantages compared to the prior art.

The combining apparatus herein described may be required to be used externally of buildings and/or in hazardous environmental conditions such as high or low temperatures. As a result of this the apparatus may be provided with protective housing which has the required characteristics to ensure relatively stable environmental conditions in which the apparatus can operate.

Thus in accordance with the invention there is provided combining apparatus of a form which ensures the required isolation and separation of the frequency sub bands used for the transmission of signals from a plurality of base transceiver stations and ensures that all received signals in a wider known or predetermined frequency band are made available for use as required by the said base transceiver stations while, at the same time, allowing the required performance, size and/or expense of the filters used in the combining apparatus to be reduced.

## Claims

1. Combining apparatus for the transmission and/or receiving of data signals for use in wireless communication apparatus, said combining apparatus including two or more filters (17, 17') in a receive signal path which are tuned to allow signals received within a known frequency passband to pass through the same, said apparatus including at least two signal splitting/combining networks (21, 23); the first splitting/combining network (23) positioned between the filters (17, 17') on one side and a port (27) connectable to a first base transceiver station (7) and a port (25) connectable to an antenna (1) in use, and the at least second splitting/combining network (21) positioned between the filters (17, 17') and a port (29) connectable to a second base transceiver station (7') in use, **characterised in that** each filter (17, 17') for the received signal path is tuned such that the return loss and insertion loss values for said filter are substantially the same.

2. Apparatus according to claim 1 wherein each filter (17, 17') for the received signal path is tuned to have substantially 3dB return and insertion losses.

3. Apparatus according to claim 1 wherein the filters provided in the received signal path of the combining apparatus distinguish between signals which are received within the known frequency band and those that are not, wherein those signals which are received within the known frequency band are allowed to pass through the filters such that the return loss and insertion loss values for said filter are substantially the same, and those signals which are received but which are not within the known frequency band are not allowed to pass through the filters and are reflected.

4. Apparatus according to claim 1 wherein the combining apparatus includes a first receive signal filter (17) and a second receive signal filter (17'), said filters (17, 17') arranged such that a receive signal passing to the combining apparatus at the antenna port (25) is split with a phase difference between the part of the signal which is passed to the first receiving signal filter (17) and the other part of the signal which is passed to the second receiving signal filter (17'), wherein said first and second receive signal filters (17, 17') have said known frequency passband which defines a range of sub-frequencies which can pass through the same and within which the said received signal falls.

5. Apparatus according to claim 3 wherein the signals that are reflected by the filters (17, 17') are recombined in phase at the port (27) from the combining apparatus to one of the base transceiver stations (7) and the signals that have passed through the filters (17, 17') are recombined in phase at the port (29) to pass to the other base transceiver station (7').

6. Apparatus according to claim 1 wherein received signals that are associated with either of the base transceiver station ports (27, 29) are split such that substantially half the power passes to each base transceiver station (7, 7') in use.

7. Apparatus according to claim 4 wherein the combining apparatus includes one or more filters (15, 15') provided in a transmit path to allow the passage through the same of signals transmitted from the port (29) connectable to the second base transceiver station (7')in one of the the sub-band frequencies while those signals transmitted from the port (27 connectable to the first base transceiver station (7) in another sub-band frequency are rejected by the filters (15, 15') and passed to the port (25) connectable to the antenna (1).

8. Apparatus according to claim 7 wherein a signal transmitted to the combining apparatus by the first or second base transceiver station (7, 7') enters one of the splitting/combining networks (21, 23) and is split in two with substantially half the signal passing to a first transmit signal path filter (15) and half the signal passing to a second transmit signal path filter (15').

9. Apparatus according to claim 1 wherein a splitting/combining network (21, 23) provides a phase difference between the signals passed to the filters (17, 17').

10. Apparatus according to claim 9 wherein the filters (17, 17') are tuned to have substantially the same performance and therefore the signals that they pass to the second of the signal splitting/combining networks (21, 23) remains out of phase by the same amount.

11. Apparatus according to claim 1 wherein the signals received by the combining apparatus within the known frequency passband comprise received signals in a first sub-band of said known frequency passband for receiving by the first base transceiver station (7) and received signals in a second sub-band of said known frequency passband for receiving by the second base transceiver station (7').

12. Apparatus according to claim 11 wherein the second sub-band is distinct from the first sub-band.

13. Apparatus according to claim 1 wherein the filters (15, 15') in the apparatus provided for transmitted signals allow transmitted signals in a frequency sub-band of the known frequency passband used by one of the first or second connectable base transceiver stations (7, 7')to pass therethrough and the filters (17, 17') provided in the apparatus for received signals allow signals in the frequency sub-band used by both of the said first and second connectable base transceiver stations (7, 7') to pass therethrough to each of the first and second base transceiver stations.

14. Apparatus according to claim 11 wherein the known frequency passband is wider than that defined by highest and lowest frequency values of the first and second frequency sub-bands.

15. A method of transmitting and/or receiving data signals in wireless communication apparatus using combining apparatus, said method including the steps of passing received signals within a known frequency passband through two or more filters (17, 17') in a receive signal path of the combining apparatus, splitting and combining the signal using at least two signal splitting/combining networks (21, 23); the first splitting/combining network (23) positioned between the filters (17, 17') on one side and a port (27) connectable to a first transceiver station (7) and a port (25) connectable to an antenna (1) in use, and the at least second splitting/combining network (21) positioned between the filters (17, 17') and a port (29) connectable to a second base transceiver station (7') in use, **characterised in that** each filter (17, 17') is tuned such that the return loss and insertion loss values for said filter are substantially the same.

## Patentansprüche

1. Kombinierungsvorrichtung zum Senden und/oder Empfangen von Datensignalen zur Verwendung in drahtlosen Kommunikationsvorrichtungen, wobei die genannte Kombinierungsvorrichtung zwei oder mehr Filter (17, 17') in einem Empfangssignalpfad beinhaltet, die so eingestellt sind, dass sie in einem bekannten Frequenzpassband empfangene Signale durchlassen, wobei die genannte Vorrichtung wenigstens zwei Signalteilungs-/Kombinierungsnetzwerke (21, 23) umfasst; wobei das erste Teilungs-/Kombinierungsnetzwerk (23) zwischen den Filtern (17, 17') auf einer Seite und einem an einer ersten Base Transceiver Station (7) anschließbaren Port (27) und einem an einer Antenne (1) anschließbaren Port (25) beim Gebrauch positioniert ist, und wobei das wenigstens zweite Teilungs-/Kombinierungsnetzwerk (21) zwischen den Filtern (17, 17') und einem an einer zweiten Base Transceiver Station (7') anschließbaren Port (29) beim Gebrauch positioniert ist, **dadurch gekennzeichnet, dass** jedes Filter (17, 17') für den empfangenen Signalpfad so eingestellt ist, dass die Rückflussdämpfungs- und Einfügungsdämpfungswerte für das genannte Filter im Wesentlichen gleich sind.

2. Vorrichtung nach Anspruch 1, wobei jedes Filter (17, 17') für den empfangenen Signalpfad so abgestimmt ist, dass es im Wesentlichen 3 dB Rückfluss- und Einfügungsdämpfung hat.

3. Vorrichtung nach Anspruch 1, wobei die im empfangenen Signalpfad der Kombinierungsvorrichtung bereitgestellten Filter zwischen innerhalb des bekannten Frequenzbands empfangenen und nicht empfangenen Signalen unterscheiden, wobei die innerhalb des bekannten Frequenzbands empfangenen Signale durch die Filter passieren können, so dass die Rückfluss- und Einfügungsdämpfungswerte für das genannte Filter im Wesentlichen gleich sind, und diejenigen Signale, die empfangen werden, aber nicht in das bekannte Frequenzband fallen, nicht durch die Filter gelassen werden und reflektiert werden.

4. Vorrichtung nach Anspruch 1, wobei die Kombinierungsvorrichtung ein erstes Empfangssignalfilter (17) und ein zweites Empfangssignalfilter (17') beinhaltet, wobei die genannten Filter (17, 17') so ausgelegt sind, dass ein zu der Kombinierungsvorrichtung am Antennenport (25) durchgelassenes Empfangssignal mit einer Phasendifferenz zwischen dem Teil des Signals, das zum ersten Empfangssignalfilter (17) durchgelassen wird, und dem anderen Teil des Signals, das zum zweiten Empfangssignalfilter (17') durchgelassen wird, geteilt wird, wobei die genannten ersten und zweiten Empfangssignalfilter (17, 17') das genannte bekannte Frequenzpassband haben, das einen Bereich von Subfrequenzen definiert, die durch dieses passieren können und in die das genannte empfangene Signal fällt.

5. Vorrichtung nach Anspruch 3, wobei die Signale, die von den Filtern (17, 17') reflektiert werden, phasengleich am Port (27) von der Kombinierungsvorrichtung zu einer der Base Transceiver Stationen (7) rekombiniert werden, und die Signale, die durch die Filter (17, 17') gelassen wurden, phasengleich am Port (29) rekombiniert werden, so dass sie zu der anderen Base Transceiver Station (7') passieren.

6. Vorrichtung nach Anspruch 1, wobei mit einem der Base Transceiver Stationsports (27, 29) assoziierte empfangene Signale so geteilt werden, dass im Wesentlichen die Hälfte der Leistung beim Gebrauch zu jeder Base Transceiver Station (7, 7') passiert.

7. Vorrichtung nach Anspruch 4, wobei die Kombinierungsvorrichtung ein oder mehrere in einem Sendepfad bereitgestellte Filter (15, 15') beinhaltet, um Signale, die von dem an der zweiten Base Transceiver Station (7') anschließbaren Port (29) auf einer der Subbandfrequenzen gesendet werden, durchzulassen, während die Signale, die von dem an der ersten Base Transceiver Station (7) anschließbaren Port (27) auf einer anderen Subbandfrequenz gesendet werden, von den Filtern (15, 15') zurückgewiesen und zu dem an der Antenne (1) anschließbaren Port (25) durchgelassen werden.

8. Vorrichtung nach Anspruch 7, wobei ein Signal, das von der ersten oder zweiten Base Transceiver Station (7, 7') zur Kombinierungsvorrichtung gesendet wird, in eines der Teilungs-/Kombinierungsnetzwerke (21, 23) eintritt und zweigeteilt wird, wobei im Wesentlichen die Hälfte des Signals zu einem ersten Sendesignalpfadfilter (15) passiert und die Hälfte des Signals zu einem zweiten Sendesignalpfadfilter (15') passiert.

9. Vorrichtung nach Anspruch 1, wobei ein Teilungs-/Kombinierungsnetzwerk (21, 23) eine Phasendifferenz zwischen den zu den Filtern (17, 17') durchgelassenen Signalen bereitstellt.

10. Vorrichtung nach Anspruch 9, wobei die Filter (17, 17') so abgestimmt sind, dass sie im Wesentlichen dieselbe Leistung haben, und daher die Signale, die sie zum zweiten der Signalteilungs-/Kombinierungsnetzwerke (21, 23) durchlassen, um denselben Betrag phasenverschoben sind.

11. Vorrichtung nach Anspruch 1, wobei die von der Kombinierungsvorrichtung innerhalb des bekannten Frequenzpassbands empfangenen Signale empfangene Signale in einem ersten Subband des genannten Frequenzpassbands zum Empfangen durch die erste Base Transceiver Station (7) und empfangene Signale in einem zweiten Subband des genannten bekannten Frequenzpassbands zum Empfangen durch die zweite Base Transceiver Station (7') umfassen.

12. Vorrichtung nach Anspruch 11, wobei sich das zweite Subband vom ersten Subband unterscheidet.

13. Vorrichtung nach Anspruch 1, wobei die Filter (15, 15') in der für gesendete Signale bereitgestellten Vorrichtung gesendete Signale in einem Frequenzsubband des bekannten Frequenzpassbands, das von der ersten oder der zweiten anschließbaren Base Transceiver Stationen (7, 7') benutzt wird, durchlassen, und die in der Vorrichtung für empfangene Signale bereitgestellten Filter (17, 17') Signale in dem Frequenzsubband, das von der ersten und der zweiten anschließbaren Base Transceiver Station (7, 7') benutzt wird, zu jeder aus erster und zweiter Base Transceiver Station durchlassen.

14. Vorrichtung nach Anspruch 11, wobei das bekannte Frequenzpassband breiter ist als das, das von den höchsten und tiefsten Frequenzwerten des ersten und zweiten Frequenzsubbands definiert wird.

15. Verfahren zum Senden und/oder Empfangen von Datensignalen in drahtlosen Kommunikationsvorrichtungen unter Verwendung einer Kombinierungsvorrichtung, wobei das genannte Verfahren die folgenden Schritte beinhaltet: Durchlassen von empfangenen Signalen innerhalb eines bekannten Frequenzbands durch zwei oder mehr Filter (17, 17') in einem Empfangssignalpfad der Kombinierungsvorrichtung, Teilen und Kombinieren des Signals mit Hilfe von wenigstens zwei Signalteilungs-/Kombinierungsnetzwerken (21, 23); wobei das erste Teilungs-/Kombinierungsnetzwerk (23) zwischen den Filtern (17, 17') auf einer Seite und einem an einer ersten Base Transceiver Station (7) anschließbaren Port (27) und einem an einer Antenne (1) anschließbaren Port (25) beim Gebrauch positioniert ist, und wobei das wenigstens zweite Teilungs-/Kombinierungsnetzwerk (21) zwischen den Filtern (17, 17') und einem an einer zweiten Base Transceiver Station (7') anschließbaren Port (29) beim Gebrauch positioniert ist, **dadurch gekennzeichnet, dass** jedes Filter (17, 17') so eingestellt ist, dass die Rückflussdämpfungs- und Einfügungsdämpfungswerte für das genannte Filter im Wesentlichen gleich sind.

## Revendications

1. Appareil de combinaison pour l'émission et/ou la réception de signaux de données pour une utilisation dans un appareil de communication sans fil, ledit appareil de combinaison incluant deux ou plusieurs filtres (17, 17') dans un trajet de signaux de réception qui sont accordés de façon à autoriser des signaux reçus au sein d'une bande passante fréquencielle connue à passer à travers ceux-ci, ledit appareil incluant au moins deux réseaux de division/de combinaison de signaux (21, 23); le premier réseau de division/de combinaison (23) étant positionné entre les filtres (17, 17') d'un côté et un port (27) connectable à une première station émettrice-réceptrice de base (7) et un port (25) connectable à une antenne (1) en utilisation, et ledit au moins deuxième réseau de division/de combinaison (21) étant positionné entre les filtres (17, 17') et un port (29) connectable à une deuxième station émettrice-réceptrice de base (7') en utilisation, **caractérisé en ce que** chaque filtre (17, 17') pour le trajet de signaux reçus est accordé de telle sorte que les valeurs de perte de retour et de perte d'insertion pour ledit filtre soient sensiblement les mêmes.

2. Appareil selon la revendication 1, chaque filtre (17, 17') pour le trajet de signaux reçus étant accordé pour avoir des pertes de retour et d'insertion de sensiblement 3 dB.

3. Appareil selon la revendication 1, les filtres prévus dans le trajet de signaux reçus de l'appareil de combinaison faisant la distinction entre des signaux qui sont reçus au sein de la bande fréquencielle connue et ceux qui ne le sont pas, cas dans lequel ces signaux qui sont reçus au sein la bande fréquencielle connue sont autorisés à passer à travers les filtres de telle sorte que les valeurs de perte de retour et de perte d'insertion pour ledit filtre soient sensiblement les mêmes, et ces signaux qui sont reçus mais qui ne se trouvent pas au sein de la bande fréquencielle connue ne sont pas autorisés à passer à travers les filtres et sont réfléchis.

4. Appareil selon la revendication 1, l'appareil de combinaison incluant un premier filtre de signaux de réception (17) et un deuxième filtre de signaux de réception (17'), lesdits filtres (17, 17') étant agencés de telle sorte qu'un signal de réception passant à l'appareil de combinaison au niveau du port d'antenne (25) soit divisé avec une différence de phase entre la partie du signal qui est passée au premier filtre de signaux de réception (17) et l'autre partie du signal qui est passée au deuxième filtre de signaux de réception (17'), cas dans lequel lesdits premier et deuxième filtres de signaux de réception (17, 17') ont ladite bande passante fréquencielle connue qui définit une gamme de sous-fréquences qui peuvent passer à travers ceux-ci et au sein desquelles se situe ledit signal reçu.

5. Appareil selon la revendication 3, les signaux qui sont réfléchis par les filtres (17, 17') étant recombinés en phase au niveau du port (27) à partir de l'appareil de combinaison vers l'une des stations émettrices-réceptrices de base (7), et les signaux qui ont passé à travers les filtres (17, 17') étant recombinés en phase au niveau du port (29) pour passer à l'autre station émettrice-réceptrice de base (7').

6. Appareil selon la revendication 1, les signaux reçus qui sont associés à l'un ou l'autre des ports de station émettrice-réceptrice de base (27, 29) étant divisés de telle sorte que sensiblement la moitié de la puissance passe à chaque station émettrice-réceptrice de base (7, 7') en utilisation.

7. Appareil selon la revendication 4, l'appareil de combinaison incluant un ou plusieurs filtres (15, 15') prévus dans un trajet d'émission pour permettre le passage à travers ceux-ci de signaux émis à partir du port (29) connectable à la deuxième station émettrice-réceptrice de base (7') dans l'une des fréquences de sous-bande, tandis que ces signaux émis à partir du port (27) connectable à la première station émettrice-réceptrice de base (7) dans une autre fréquence de sous-bande sont rejetés par les filtres (15, 15') et sont passés au port (25) connectable à l'antenne (1).

8. Appareil selon la revendication 7, un signal émis à l'appareil de combinaison par la première ou la deuxième station émettrice-réceptrice de base (7, 7') entrant dans l'un des réseaux de division/de combinaison (21, 23) et étant divisé en deux alors que sensiblement la moitié du signal passe à un premier filtre de trajet de signaux d'émission (15) et la moitié du signal passe à un deuxième filtre de trajet de signaux d'émission (15').

9. Appareil selon la revendication 1, un réseau de division/de combinaison (21, 23) procurant une différence de phase entre les signaux passés aux filtres (17, 17').

10. Appareil selon la revendication 9, les filtres (17, 17') étant accordés pour avoir sensiblement la même performance et par conséquent les signaux qu'ils passent au deuxième réseau parmi les réseaux de division/de combinaison de signaux (21, 23) restent déphasés suivant la même ampleur.

11. Appareil selon la revendication 1, les signaux reçus par l'appareil de combinaison au sein de la bande passante fréquencielle connue comprenant des signaux reçus dans une première sous-bande de ladite bande passante fréquencielle connue pour une réception par la première station émettrice-réceptrice de base (7), et des signaux reçus dans une deuxième sous-bande de ladite bande passante fréquencielle connue pour une réception par la deuxième station émettrice-réceptrice de base (7').

12. Appareil selon la revendication 11, la deuxième sous-bande étant distincte de la première sous-bande.

13. Appareil selon la revendication 1, les filtres (15, 15') dans l'appareil prévus pour des signaux émis autorisant les signaux émis dans une sous-bande de fréquence de la bande passante fréquencielle connue utilisée par une station parmi les première ou deuxième stations émettrices-réceptrices de base connectables (7, 7') à passer à travers ceux-ci, et les filtres (17, 17') prévus dans l'appareil pour des signaux reçus autorisant les signaux dans la sous-bande de fréquence utilisée par les deux stations desdites première et deuxième stations émettrices-réceptrices de base connectables (7, 7') à passer à travers ceux-ci vers chacune des première et deuxième stations émettrices-réceptrices de base.

14. Appareil selon la revendication 11, la bande passante fréquencielle connue étant plus large que celle définie par les valeurs de fréquence les plus élevées et les plus basses des première et deuxième sous-bandes de fréquence.

15. Procédé d'émission et/ou de réception de signaux de données dans un appareil de communication sans fil utilisant un appareil de combinaison, ledit procédé incluant les étapes consistant à faire passer des signaux reçus au sein d'une bande passante fréquencielle connue à travers deux ou plusieurs filtres (17, 17') dans un trajet de signaux de réception de l'appareil de combinaison, à diviser et combiner le signal grâce à l'utilisation d'au moins deux réseaux de division/de combinaison de signaux (21, 23) ; le premier réseau de division/de combinaison (23) étant positionné entre les filtres (17, 17') d'un côté et un port (27) connectable à une première station émettrice-réceptrice (7) et un port (25) connectable à une antenne (1) en utilisation, et ledit au moins deuxième réseau de division/de combinaison (21) étant positionné entre les filtres (17, 17') et un port (29) connectable à une deuxième station émettrice-réceptrice de base (7') en utilisation, **caractérisé en ce que** chaque filtre (17, 17') est accordé de telle sorte que les valeurs de perte de retour et de perte d'insertion pour ledit filtre soient sensiblement les mêmes.
